(19) Europäisches Patentamt
European Patent Office
Office européen des brevets

(11) **EP 3 821 324 B1**

(12) **EUROPÄISCHE PATENTSCHRIFT**

(45) Veröffentlichungstag und Bekanntmachung des Hinweises auf die Patenterteilung:
**10.04.2024 Patentblatt 2024/15**

(21) Anmeldenummer: **19702839.2**

(22) Anmeldetag: **28.01.2019**

(51) Internationale Patentklassifikation (IPC):
*G06F 3/01* *(2006.01)*        *G06F 3/0354* *(2013.01)*
*G06F 3/041* *(2006.01)*        *H02N 2/04* *(2006.01)*
*H10N 30/20* *(2023.01)*

(52) Gemeinsame Patentklassifikation (CPC):
**G06F 3/03545; G06F 3/016; H02N 2/043;**
**H10N 30/206;** G06F 3/041; H10N 30/50

(86) Internationale Anmeldenummer:
**PCT/EP2019/051998**

(87) Internationale Veröffentlichungsnummer:
**WO 2020/011403 (16.01.2020 Gazette 2020/03)**

(54) **ANORDNUNG ZUR ERZEUGUNG EINES HAPTISCHEN SIGNALS**

ARRANGEMENT FOR PRODUCING A HAPTIC SIGNAL

AGENCEMENT POUR PRODUIRE UN SIGNAL HAPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.07.2018 DE 102018116912**
**24.10.2018 DE 102018126473**

(43) Veröffentlichungstag der Anmeldung:
**19.05.2021 Patentblatt 2021/20**

(73) Patentinhaber: **TDK Electronics AG**
**81671 München (DE)**

(72) Erfinder:
• **HOPFER, Markus**
**8541 Schwanberg (AT)**
• **KASTL, Harald**
**8524 Bad Gams (AT)**
• **NEUWIRTH, Daniel**
**94474 Vilshofen (DE)**
• **PUCHLEITNER, Roman**
**8083 St. Stefan (AT)**

(74) Vertreter: **Epping - Hermann - Fischer**
**Patentanwaltsgesellschaft mbH**
**Schloßschmidstraße 5**
**80639 München (DE)**

(56) Entgegenhaltungen:
EP-A1- 2 889 727          WO-A1-2016/207751
DE-A1-102016 116 763      DE-A1-102016 122 610
US-A1- 2012 274 599

## Beschreibung

Die vorliegende Erfindung betrifft eine Anordnung aufweisend ein Bedienelement und ein Bauteil zur Erzeugung eines haptischen Signals sowie eine Anordnung aufweisend mehrere Bauteile zur Erzeugung eines haptischen Signals. Ferner betrifft die Erfindung ein medizinisches Gerät, eine Maschine für einen industriellen Einsatz, ein Küchengerät, ein elektronisches Verdampfungsgerät, ein elektronisches Gerät und einen Stylus, die jeweils eine derartige Anordnung aufweisen.

Zur besseren Bedienbarkeit werden mechanische Bedienelemente von elektronischen Geräten, zum Beispiel Mobiltelefonen, Tablets, Laptops oder Eingabestiften, sogenannten Stylus, zunehmend mit einer berührungsempfindlichen, haptischen Rückmeldung ausgestattet. Die haptische Rückmeldung kann dabei erzeugt werden, indem ein Bedienelement verschoben beziehungsweise angehoben wird. Hier sind Verschiebungen im Bereich von einigen Mikrometern und Ausschlagszeiten von wenigen Millisekunden erwünscht, um hauptsächlich die sogenannten Pacini Korpuskel und auch anderen Druckrezeptoren eines Nutzers anzuregen.

EP 2 889 727 A1 zeigt eine Vorrichtung mit einem berührungsempfindlichen Kontroll-Panel, die dazu ausgestaltet ist, ein haptisch wahrnehmbares Signal zu erzeugen.

Die vorliegende Erfindung löst die Aufgabe, eine verbesserte Anordnung anzugeben, bei der ein Bauteil vorgesehen ist, das ein haptisches Signal mit einem geringen Platzbedarf erzeugen kann. Eine weitere Aufgabe ist es, eine verbesserte Anordnung aufweisend mehrere Bauteile zur Erzeugung eines haptischen Signals anzugeben.

Die Aufgaben werden durch die Gegenstände der unabhängigen Ansprüche gelöst.

Es wird eine Anordnung vorgeschlagen, die ein Bedienelement und ein Bauteil zur Erzeugung eines haptischen Signals aufweist, wobei das Bauteil einen piezoelektrischen Aktuator aufweist und unter dem Bedienelement angeordnet ist und dazu ausgestaltet ist, an dem Bedienelement eine Vibration zu erzeugen, wobei es sich bei dem Bedienelement um einen Bereich einer Gehäusewand handelt, wobei die Gehäusewand in dem Bereich, der als Bedienelement dient, eine größere mechanische Verformbarkeit aufweist als in anderen Bereichen.

Als Bedienelement kann hierbei jedes Element bezeichnet werden, über das ein Nutzer der Anordnung oder eines Gerätes, das die Anordnung aufweist, einen Steuerbefehl an die Anordnung oder an andere Komponenten des Geräts erteilen kann. Bei dem Bedienelement kann es sich beispielsweise um ein mechanisches Element, beispielsweise einen Knopf, handeln. Bei dem Bedienelement kann es sich um jedes Element eines Geräts handeln, das durch eine Berührung des Nutzers betätigt wird. Es kann sich beispielsweise um einen Druckknopf, einen Drehknopf, einen Regler oder einen berührungsempfindlichen Bereich einer Oberfläche des elektronischen Geräts handeln.

Die Verwendung eines piezoelektrischen Aktuators zur Erzeugung eines haptischen Signals bietet wesentliche Vorteile. Ein piezoelektrischer Aktuator weist eine kurze Ansprech- und Abklingzeit auf. Dementsprechend können der Zeitpunkt und der Zeitraum, in dem das haptische Signal erzeugt wird, sehr genau bestimmt werden. Ferner kann durch eine Variation der an dem piezoelektrischen Aktuator angelegten Frequenz und Spannung bestimmt werden, mit welcher Amplitude und welcher Frequenz das Bedienelement vibriert. Dadurch kann es ermöglicht werden, unterschiedliche haptische Signale an dem Bedienelement zu erzeugen.

Das Bauteil kann unter dem Bedienelement angeordnet sein. Dabei können das Bedienelement und das Bauteil aneinander anliegen und sich berühren. Insbesondere kann ein mechanisches Verstärkungselement des Bauteils an einem unteren Ende des Bedienelementes anliegen. Als unteres Ende kann dabei eine Seite des Bedienelements bezeichnet sein, die von der Seite des Bedienelements, die ein Nutzer bei der Betätigung des Bedienelements berührt, wegweist.

Piezoelektrische Aktuatoren weisen im Vergleich zu anderen Bauteilen zur Erzeugung einer Vibration, beispielsweise Unwuchtmotoren oder Linearresonatoren, ein kleines Volumen aus. Durch die Verwendung eines piezoelektrischen Aktuators in dem Bauteil kann daher ein Bauteil konstruiert werden, das einen sehr geringen Platzbedarf aufweist. Dementsprechend kann das Bauteil hohe Anforderungen bezüglich einer Miniaturisierung erfüllen.

Gemäß einem Ausführungsbeispiel können das Bedienelement und das Bauteil zur Erzeugung eines haptischen Signals eine Einheit bilden. Als "Einheit" kann hierbei eine Baueinheit oder ein Modul bezeichnet werden, das als Ganzes in einem Gerät eingebaut werden kann. Insbesondere in den Ausführungsbeispielen, in den es sich bei dem Bedienelement um einen Bereich eines Gehäuses handelt, können Bedienelement und Bauteil als Einheit ausgebildet sein. Auch in den anderen Ausführungsbeispielen können Bedienelement und Bauteil als Einheit bzw. Modul ausgebildet sein. Wird die Anordnung beispielsweise in einem Stylus verwendet, können das Bedienelement und das Bauteil zur Erzeugung eines haptischen Signals eine Einheit bilden.

Der piezoelektrische Aktuator kann dazu ausgestaltet sein, infolge einer Betätigung des Bedienelements verformt zu werden und dabei die Betätigung des Bedienelementes zu detektieren. Dementsprechend kann das Bauteil zur Erzeugung des haptischen Signals auch als Sensor eingesetzt werden, der eine Betätigung des Bedienelements erkennt. Das Bauteil kann somit eine Doppelfunktion besitzen. In dem elektronischen Gerät kann auf separate Komponenten zur Erzeugung eines haptischen Signals und zur Erkennung der Betätigung des Bedienelements verzichtet werden.

Bei dem Bedienelement kann es sich in einem Vergleichsbeispiel um einen Knopf handeln. Beispielsweise kann es sich um einen sogenannten Home-Button handeln. Es kann sich bei dem Bedienelement auch um Knöpfe handeln, die an einer seitlichen Gehäusewand des Gerätes angeordnet sind.

Bei dem Bedienelement handelt es sich um einen Bereich der Gehäusewand, der als Bedienelement dient. Wird ein Bereich der Gehäusewand als Bedienelement verwendet, sind keine Öffnungen in der Gehäusewand erforderlich und dementsprechend kann auf Dichtungen verzichtet werden, die derartige Öffnungen üblicherweise abdichten. Bei konventionellen Bedienelementen, zum Beispiel Knöpfen in einer Gehäusewand, sind Dichtungen üblicherweise nötig, um das Gehäuse gegen das Eindringen von Wasser, Staub oder Schmutz zu schützen. Durch den Verzicht auf die Dichtungen kann die Fertigung des elektronischen Gerätes vereinfacht werden und die Kosten für das elektronische Gerät reduziert werden.

Die Gehäusewand weist in dem Bereich, der als Bedienelement dient, eine größere mechanische Verformbarkeit auf als in anderen Bereichen. Dadurch kann sichergestellt werden, dass eine Vibration auf den Bereich der Gehäusewand beschränkt bleibt, der als Bedienelement dient. Es ist wünschenswert, dass nur das Bedienelement und nicht das ganze elektronische Gerät vibriert, um den Nutzer ein angenehmes Nutzungserlebnis zu vermitteln.

Die Gehäusewand kann in dem Bereich, der als Bedienelement dient, dünner sein als in einem anderen Bereich. Alternativ oder ergänzend kann der Bereich der Gehäusewand, der als Bedienelement dient, durch zumindest eine Kerbe von den übrigen Bereichen der Gehäusewand abgetrennt sein. Die Kerbe und die dünnere Ausgestaltung können es jeweils ermöglichen, Vibrationen lokal auf den Bereich der Gehäusewand zu beschränken, der als Bedienelement dient.

Auf dem Bereich der Gehäusewand, der das Bedienelement bildet, kann ein Symbol angeordnet sein. Das Symbol kann auf eine Bedienungsfunktion hinweisen. Die Bedienfunktion kann durch ein Drücken auf den Bereich ausgelöst werden. Beispielsweise kann es sich bei der Bedienfunktion um das Erhöhen oder Reduzieren einer Lautstärke handeln.

Das Bauteil zur Erzeugung eines haptischen Signals kann zwischen dem Bedienelement und einer Rückwand eingeklemmt sein. Dabei handelt es sich bei dem Bedienelement um den Bereich der Gehäusewand. Die Rückwand kann durch einen innenliegenden Bereich der Gehäusewand gebildet werden. Das Bedienelement kann eine spaltenlose Bedienoberfläche sein.

Eine Steifigkeit der Rückwand kann größer sein als eine Steifigkeit des piezoelektrischen Aktuators. Dementsprechend wird die Rückwand nicht oder zumindest nur in unwesentlichem Maße in Vibration versetzt, wenn der piezoelektrische Aktuator vibriert. Alternativ oder ergänzend kann eine Steifigkeit des piezoelektrischen Aktuators größer sein als eine Steifigkeit des Bedienelements. Dementsprechend kann eine Vibration des piezoelektrischen Aktuators auf das Bedienelement übertragen werden. Die Steifigkeit des Bedienelements und der Rückwand werden unter anderem durch die jeweilige Dicke bestimmt. Das Bedienelement kann eine geringere Dicke als die Rückwand aufweisen. Dieses kann bewirken, dass die Steifigkeit des Bedienelements kleiner als die Steifigkeit der Rückwand ist. Die Steifigkeit des Bedienelements kann 1 % bis 50 % der Steifigkeit des piezoelektrischen Aktuators betragen.

Die Steifigkeit ist eine Größe in der Technischen Mechanik. Sie beschreibt den Widerstand eines Körpers gegen elastische Verformung durch eine Kraft oder ein Moment. Bei der hier genannten Steifigkeit kann es sich insbesondere um eine Biegesteifigkeit der entsprechenden Elemente handeln.

Dadurch, dass das Bedienelement eine kleinere Steifigkeit als der piezoelektrische Aktuator und die Rückwand aufweist, kann sichergestellt werden, dass sich ausschließlich oder zumindest fast ausschließlich das Bedienelement verformt, wenn der piezoelektrische Aktuator in Vibration versetzt wird. Dadurch kann eine Stärke des haptischen Signals maximiert werden. Durch eine geeignete Wahl der Dicke des Bedienelements und der Verbindung zwischen dem Bedienelement und der Rückwand kann eine Federwirkung des Bedienelements optimiert werden.

Das Bedienelement und die Rückwand können fest miteinander verbunden sein. Beispielsweise können das Bedienelement und die Rückwand miteinander verschraubt sein. Alternativ können das Bedienelement und die Rückwand einstückig sein und beispielsweise aus verschiedenen Bereichen einer einzigen Gehäusewand gebildet werden. Dabei kann das Bedienelement von einem nach außenweisenden Bereich der Gehäusewand gebildet werden und die Rückwand von einem ins Gehäuseinnere weisenden Bereich der Gehäusewand gebildet werden. Die Gehäusewand kann einen Hohlraum aufweisen, der den Bereich, der das Bedienelement bildet, und den Bereich, der die Rückwand bildet, trennt. In dem Hohlraum kann das Bauteil zur Erzeugung des haptischen Signals angeordnet sein.

Das Bauteil zur Erzeugung eines haptischen Signals kann an dem Bedienelement und/oder an der Rückwand befestigt sein. Insbesondere kann das Bauteil an dem Bedienelement und/oder der Rückwand durch eine Klebeverbindung befestigt sein. Durch die Befestigung des Bauteils an zumindest einem aus Bedienelement und Rückwand kann ein Verrutschen des Bauteils im Betrieb verhindert werden.

Das Bauteil kann ein mechanisches Verstärkungselement aufweisen, das an dem piezoelektrischen Aktuator derart befestigt ist, dass durch eine Längenänderung des Aktuators in seine Längsrichtung ein Bereich des mechanischen Verstärkungselements in eine zu der Längsrichtung senkrechte Richtung bewegt wird. Der Aktuator kann dabei derart angeordnet sein, dass seine Längsrichtung parallel zu der Gehäusewand ist. Die Längsrichtung kann senkrecht zu einer Betätigungsrichtung des Betätigungselements sein. Die Längsrichtung kann senkrecht zu einer Stapelrichtung sein. Durch das mechanische Verstärkungselement kann somit die durch den d31-Effekt hervorgerufene Längenänderung des piezoelektrischen Aktuators umgewandelt werden in eine zu der Längenänderung senkrechte Hubbewegung. Dabei kann die Hubbewegung eine wesentlich größere Amplitude haben als die Längenänderung. Beispielsweise kann die Amplitude der Hubbewegung um das 5- bis 40-Fache der Amplitude der Längenänderung betragen. Insbesondere kann die Amplitude der Hubbewegung das 10- bis 20-Fache der Amplitude der Längenänderung betragen. Durch die Kombination des Aktuators mit dem Verstärkungselement können somit deutlich stärkere Vibrationen des Bedienelementes bewirkt werden.

Das Verstärkungselement kann ein Metallbügel sein. Bei dem Metall kann es sich beispielsweise um Titan handeln. Titan weist den Vorteil auf, dass sein thermischer Ausdehnungskoeffizient sehr ähnlich zu dem thermischen Ausdehnungskoeffizienten des piezoelektrischen Aktuators ist, so dass es bei Temperaturänderungen nicht zu mechanischen Spannungen kommt.

Das mechanische Verstärkungselement kann frei von Einkerbungen sein und eine konstante Wandstärke aufweisen. Durch den Verzicht auf Einkerbungen in dem Verstärkungselement kann eine einfache Herstellung des Verstärkungselements ermöglicht werden. Das mechanische Verstärkungselement sollte insbesondere dann frei von Einkerbungen sein, wenn die Dicke des mechanischen Verstärkungselementes gering genug ist, um eine Verformung des Verstärkungselementes nicht zu sehr zu behindern. In alternativen Ausführungsformen kann das Verstärkungselement zumindest eine Einkerbung aufweisen, die einen mechanischen Widerstand gegen eine Verformung des mechanischen Verstärkungselementes reduziert. Insbesondere bei Verstärkungselementen mit einer Dicke, bei der Verformungen des Verstärkungselements viel Kraft erfordern, kann der Einsatz von Einkerbungen in dem Verstärkungselement sinnvoll sein, da die Einkerbungen die Verformung des Verstärkungselementes erleichtern können.

Das mechanische Verstärkungselement kann an dem piezoelektrischen Aktuator durch eine Klebeverbindung befestigt sein.

Das elektronische Gerät kann mehrere Bauteile zur Erzeugung eines haptischen Signals, die jeweils einen piezoelektrischen Aktuator aufweisen und nebeneinander als Array angeordnet sind, aufweisen. Das Array kann dabei aus einer einzigen Reihe von Bauteilen bestehen. Alternativ kann das Array aus Bauteilen bestehen, die zu einer m×n Matrix mit m Spalten und n Zeilen angeordnet sind, wobei m und n beliebige natürliche Zahlen sein können. Die mehreren Bauteile können unter dem Bedienelement angeordnet sein und insbesondere unmittelbar an dem Bedienelement anliegen.

Durch die Kombination mehrerer Bauteile zur Erzeugung eines haptischen Signals können verschiedene Vorteile erreicht werden. Es wird dadurch möglich, ein stärkeres haptisches Signal zu erzeugen, da die Vibrationen von mehreren Bauteilen genutzt werden können. Wird das Bauteil zusätzlich als Sensor zur Detektion einer Betätigung eines Bedienelementes verwendet, kann neben der Tatsache, dass das Bedienelement betätigt wurde, durch die Verwendung des Arrays mehrerer Bauteile auch bestimmt werden, an welcher Position des Bedienelementes die Betätigung erfolgt.

Jeder der piezoelektrischen Aktuatoren kann separat von den übrigen Aktuatoren ausgelesen und angesteuert werden. Dadurch kann jeder Aktuator separat als Sensor und zur Erzeugung eines haptischen Feedbacks genutzt werden.

Das Array von Bauteilen kann dazu ausgestaltet sein, eine Gestensteuerung des Bedienelementes zu erkennen. Das elektronische Gerät kann ferner eine Auswerteeinheit aufweisen, die dazu ausgestaltet ist, an jedem der piezoelektrischen Aktuatoren die erzeugte elektrische Spannung auszulesen, aus der an den Aktuatoren erzeugten Spannung auf das an dem jeweiligen Aktuator anliegende Druckprofil zu schließen und die Druckprofile in Gesten der Gestensteuerung umzurechnen. Es wird dementsprechend ermöglicht, ein Bauteil, das zur Erzeugung eines haptischen Signals dient, auch zur Erkennung von Steuerungsgesten zu verwenden.

Gemäß einem weiteren Aspekt betrifft die vorliegende Erfindung eine Anordnung, die mehrere Bauteile zur Erzeugung eines haptischen Signals aufweist, die jeweils einen piezoelektrischen Aktuator aufweisen, wobei die Bauteile nebeneinander zu einem Array angeordnet sind. Die Anordnung umfasst ferner eine Auswerteeinheit, die dazu ausgestaltet ist, an jedem der piezoelektrischen Aktuatoren die erzeugte elektrische Spannung auszulesen, und aus der an den Aktuatoren erzeugten Spannung auf das an dem jeweiligen Aktuator anliegende Druckprofil zu schließen. Bei den mehreren Bauteilen kann es sich um die im Zusammenhang mit dem ersten Aspekt der Erfindung beschriebenen Bauteile handeln. Insbesondere können die Bauteile die im Zusammenhang mit dem ersten Aspekt beschriebenen mechanischen Verstärkungselemente aufweisen.

Jeder der piezoelektrischen Aktuatoren kann separat von den übrigen Aktuatoren ausgelesen und angesteuert werden. Die Auswerteeinheit kann dazu ausgestaltet sein, die Druckprofile in Gesten einer Gestensteuerung umzurechnen.

Gemäß einem weiteren Aspekt betrifft die vorliegende Erfindung ein medizinisches Gerät, das eine der oben beschriebenen Anordnungen aufweist. Bei dem medizinischen Gerät kann es sich dabei um ein Ultraschallgerät handeln. Es kann sich alternativ bei dem medizinischen Gerät um einen Operationstisch handeln. Das Bedienelement kann dabei ein auf dem Operationstisch angeordnetes Element, beispielsweise ein Knopf, oder ein berührungsempfindlicher Bereich des Operationstisches sein.

Gemäß einem weiteren Aspekt betrifft die vorliegende Erfindung eine Maschine für einen industriellen Einsatz, die eine der oben beschriebenen Anordnungen aufweist. Bei der Maschine für einen industriellen Einsatz kann es sich beispielsweise um eine CNC-Fräse handeln. Das Bauteil zur Erzeugung eines haptischen Signals kann ein Bedienelement der CNC-Fräse zur Erzeugung des haptischen Signals in Vibration versetzen.

Gemäß einem weiteren Aspekt betrifft die vorliegende Erfindung ein Küchengerät, das eine der oben beschriebenen Anordnungen aufweist. Bei dem Küchengerät kann es sich beispielsweise um einen Herd oder einen Mixer handeln. Das Bedienelement kann dabei ein auf dem Herd angeordnetes Element, beispielsweise ein Knopf, oder ein berührungsempfindlicher Bereich einer Herdplatte sein.

Gemäß einem weiteren Aspekt betrifft die vorliegende Erfindung ein elektronisches Verdampfungsgerät, das eine der oben beschriebenen Anordnungen aufweist. Bei dem elektronischen Verdampfungsgerät kann es sich beispielsweise um eine E-Zigarette handeln.

Gemäß einem weiteren Aspekt betrifft die vorliegende Erfindung ein elektronisches Gerät, das eine der oben beschriebenen Anordnungen aufweist. Bei dem elektronischen Gerät kann es sich beispielsweise um ein Mobiltelefon, ein Tablet, ein Laptop, eine Smartwatch oder ein Fitness-, Herzraten-, Schlaf- oder Gesundheitstracker handeln.

Gemäß einem weiteren Aspekt betrifft die vorliegende Erfindung einen Stylus, der eine der oben beschriebenen Anordnungen aufweist. Als Stylus kann ein Eingabestift für ein elektronisches Gerät bezeichnet. Ein Stylus wird auch als Touchpen bezeichnet. Ein Stylus ist ein Stift, der zur Bedienung von Touchscreens und Tabletts verwendet werden kann.

Das Bauteil zur Erzeugung des haptischen Signals kann eine Tastspitze des Stylus in Vibration versetzt, um das haptische Signal zu erzeugen. Alternativ oder ergänzend kann das Bauteil zur Erzeugung des haptischen Signals einen Bereich eines Gehäuses des Stylus in Vibration versetzen, um das haptische Signal zu erzeugen. Dabei kann die Tastspitze unbewegt bleiben.

Im Folgenden werden bevorzugte Ausführungsbeispiele der vorliegenden Erfindung anhand der Figuren näher erläutert.

Figur 1 zeigt ein Bauteil zur Erzeugung eines haptischen Signals in perspektivischer Ansicht.

Figur 2 zeigt eine Seitenansicht des Bauteils.

Figur 3 zeigt eine Draufsicht auf die Oberseite des Bauteils.

Figur 4 zeigt schematisch einen Teil eines elektronischen Geräts.

Figur 5 zeigt einen Teil eines weiteren elektronischen Gerätes in schematischer Ansicht.

Figur 6 und Figur 7 zeigen jeweils ein elektronisches Gerät gemäß weiteren Ausführungsformen.

Figur 8 zeigt einen Stylus.

Figur 9 zeigt einen Stylus gemäß einem weiteren Ausführungsbeispiel.

Figur 10 zeigt ein weiteres Ausführungsbeispiel.

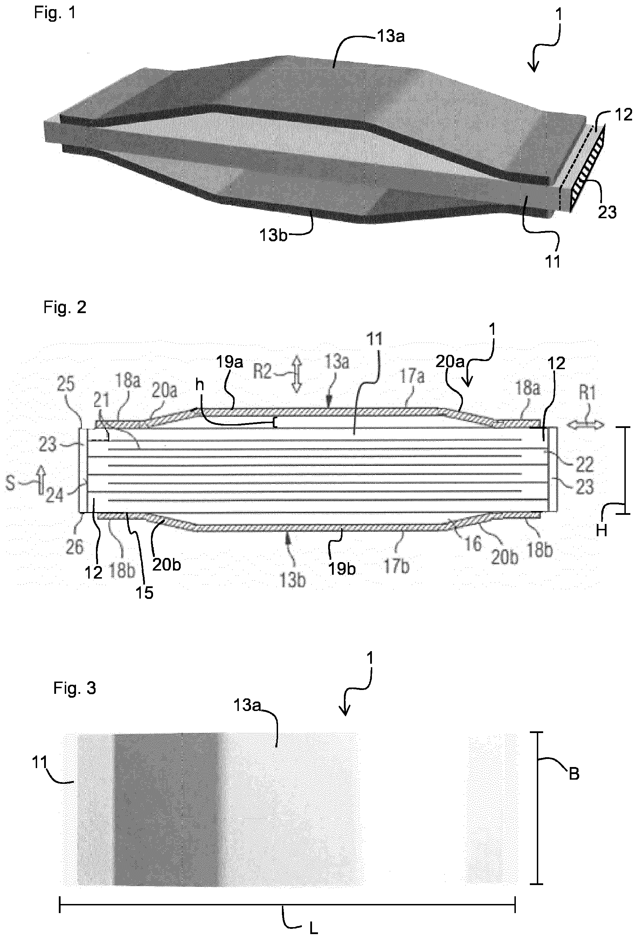

Figur 1 zeigt ein Bauteil 1 zur Erzeugung eines haptischen Signals in perspektivischer Ansicht. Figur 2 zeigt eine Seitenansicht des Bauteils 1. Figur 3 zeigt eine Draufsicht auf die Oberseite des Bauteils 1.

Das Bauteil 1 weist einen piezoelektrischen Aktuator 11 und zwei mechanischen Verstärkungselemente 13a, 13b auf. Das Bauteil 1 kann insbesondere in einem elektronischen Gerät zur Detektion von Bediensignalen und zur Erzeugung eines haptischen Signals eingesetzt werden. Alternativ kann das Bauteil auch in anderen Geräten, beispielsweise in einem medizinischen Gerät, einer Maschine für einen industriellen Einsatz, einem Küchengerät, einem elektronischen Verdampfungsgerät oder einem Stylus zur Detektion von Bediensignalen und zur Erzeugung eines haptischen Signals eingesetzt werden.

Der piezoelektrische Aktuator 11 weist einen Stapel aus in einer Stapelrichtung S abwechselnd übereinandergestapelten Innenelektroden 21 und piezoelektrischen Schichten 22 auf. Der piezoelektrische Aktuator 11 weist eine erste Außenelektrode 23, die auf einer ersten Stirnfläche 24 angeordnet ist, und eine zweite Außenelektrode 23, die auf einer zweiten Stirnfläche angeordnet ist, auf. Die Innenelektroden 21 sind in Stapelrichtung S abwechselnd mit der ersten Außenelektrode 23 oder mit der zweiten Außenelektrode 23 kontaktiert.

Bei den piezoelektrischen Schichten 22 kann es sich um Blei-Zirkonat-Titanat-Keramiken (PZT-Keramiken) handeln. Die PZT-Keramik kann ferner zusätzlich Nd und Ni enthalten. Alternativ kann die PZT-Keramik ferner zusätzlich Nd, K und gegebenenfalls Cu aufweisen. Alternativ können die piezoelektrischen Schichten 22 eine $Pb(Zr_xTi_{1-x})O_3 + y\ Pb(Mn_{1/3}Nb_{2/3})O_3$ enthaltenden Zusammensetzung aufweisen.

Die Innenelektroden 21 weisen Kupfer auf oder bestehen aus Kupfer.

Der piezoelektrische Aktuator 11 ist quaderförmig. Als Grundfläche wird dabei eine Fläche bezeichnet, deren Flächennormale in die Stapelrichtung S weist. Die Grundfläche ist rechteckig. Die längere Seite der Grundfläche definiert die Länge L des piezoelektrischen Aktuators 11 und die kürzere Seite der Grundfläche definiert die Breite B des piezoelektrischen Aktuators 11.

Der piezoelektrische Aktuator 11 weist eine Länge L zwischen 5 mm und 20 mm sowie eine Breite B zwischen 2 mm und 8 mm auf. Gemäß einem ersten Ausführungsbeispiel weist der piezoelektrische Aktuator 11 eine Länge L von 12 mm und eine Breite B von 4 mm auf. In einem zweiten Ausführungsbeispiel weist der piezoelektrische Aktuator 11 eine Länge L von 9 mm und eine Breite B von 3,75 mm auf.

Die Ausdehnung des piezoelektrischen Aktuators in Stapelrichtung S definiert die Höhe H des piezoelektrischen Aktuators 11. Die Höhe H des piezoelektrischen Aktuators 11 kann zwischen 200 $\mu$m und 1000 $\mu$m liegen. Beispielsweise beträgt die Höhe H in dem ersten und dem zweiten Ausführungsbeispiel jeweils 500 $\mu$m.

Der Aktuator 11 weist zwei Isolationsbereiche 12 auf. Der jeweilige Isolationsbereich 12 ist in einem Endbereich des Aktuators 11 ausgebildet. Insbesondere ist der jeweilige Isolationsbereich 12 im Bereich einer Stirnfläche 24 des Aktuators ausgebildet.

Im Isolationsbereich 12 reichen nur Innenelektroden 21 einer Polarität bis an die Stirnfläche 24 des Aktuators 11. Der Isolationsbereich 12 kann zur Kontaktierung des Aktuators 11 verwendet werden. Beispielsweise kann der jeweilige Isolationsbereich 12 mit den Außenelektroden 23 zur elektrischen Kontaktierung versehen werden.

Der Aktuator 11 ist so ausgestaltet, dass bei Anlegen einer elektrischen Spannung eine Verformung des Aktuators 11 stattfindet (Ausdehnung in eine erste Richtung R1). Insbesondere sind die piezoelektrischen Schichten 22 derart polarisiert, dass das Anlegen einer elektrischen Spannung zwischen den Innenelektroden 21 zu einer Querkontraktion des Aktuators 11 führt, bei der sich die Länge L des Aktuators 11 senkrecht zur Stapelrichtung S verändert. Folglich erfolgt eine Ausdehnung des Aktuators quer zur Polarisationsrichtung und zum elektrischen Feld (d31 Effekt).

Um den Effekt der Längenänderung in Stapelrichtung S weiter zu verstärken weist die Vorrichtung zwei Verstärkungselemente 13a, 13b auf. Wird an den Aktuator 11 eine Spannung angelegt, so verformen sich die Verstärkungselemente 13a, 13b zumindest teilweise in Folge der Änderung der Ausdehnung des Aktuators 11, wie später im Detail beschrieben wird. Insbesondere sind die beiden Verstärkungselemente 13a, 13b derart dimensioniert und mit dem Aktuator 11 verbunden, dass je ein Teilbereich 17a, 17b der Verstärkungselemente 13a, 13b in Folge einer Änderung der Länge L des Aktuators eine Hubbewegung in die Stapelrichtung S ausführt, wobei die Amplitude der Hubbewegung größer ist als die Amplitude der Änderung der Länge L des Aktuators.

Der Aktuator 11 ist zwischen den Verstärkungselementen 13a, 13b angeordnet. Die Verstärkungselemente 13a, 13b liegen zumindest teilweise auf der Oberseite 25 bzw. einer Unterseite 26 des Aktuators 11 auf.

Das jeweilige Verstärkungselement 13a, 13b ist einstückig ausgebildet. Das jeweilige Verstärkungselement 13a, 13b weist eine rechteckige Form auf. Das jeweilige Verstärkungselement 13a, 13b ist streifenförmig ausgebildet. Das jeweilige Verstärkungselement 13a, 13b ist gekrümmt bzw. verbogen ausgebildet. Das jeweilige Verstärkungselement 13a, 13b ist bügelförmig. Beispielsweise weist das jeweilige Verstärkungselement einen Blechstreifen auf. Das jeweilige Verstärkungselement weist Titan auf oder besteht aus Titan. Der Blechstreifen ist gebogen, wie im Folgenden im Detail erläutert wird.

Jedes der einstückigen Verstärkungselemente 13a, 13b ist in mehrere Bereiche oder Abschnitte untergliedert. So weist das jeweilige Verstärkungselement 13a, 13b einen Teilbereich oder ersten Bereich 17a, 17b auf. Der Teilbereich 17a, 17b weist jeweils einen ersten Abschnitt oder mittleren Bereich 19a, 19b auf.

Der Teilbereich 17a, 17b weist ferner jeweils zwei zweite Abschnitte oder Verbindungsbereiche 20a, 20b auf. Die beiden Verbindungsbereiche 20a, 20b des jeweiligen Verstärkungselements 13a, 13b schließen sich unmittelbar an den mittleren Bereich 19a, 19b des jeweiligen Verstärkungselements 13a, 13b an. Der mittlere Bereich 19a, 19b des jeweiligen Verstärkungselements 13a, 13b ist mit anderen Worten von den beiden Verbindungsbereichen 20a, 20b zu beiden Seiten hin umgeben.

Das jeweilige Verstärkungselement 13a, 13b weist ferner zwei Endbereiche 18a, 18b auf. Die Endbereiche 18a, 18b schließen sich unmittelbar an die Verbindungsbereiche 20a, 20b des jeweiligen Verstärkungselements 13a, 13b an. Mit andere Worten verbindet jeweils ein Verbindungsbereich 20a, 20b einen Endbereich 18a, 18b mit dem mittleren Bereich 19a, 19b eines Verstärkungselements 13a, 13b.

Die beiden Endbereiche 18a, 18b des jeweiligen Verstärkungselements liegen unmittelbar auf einer Oberfläche des Aktuators 11 auf. So liegen der erste und der zweite Endbereich 18a des ersten Verstärkungselements 13a auf einem Teilbereich der Oberseite 25 des Aktuators 11 auf. Weiterhin liegen der erste und der zweite Endbereich 18b des zweiten Verstärkungselements 13b auf einem Teilbereich der Oberseite 25 oder der Unterseite 26 des Aktuators 11 auf.

Die Endbereiche 18a, 18b sind vorzugsweise unlösbar mit der Oberfläche des Aktuators 11 verbunden. Insbesondere sind die Endbereiche 18a, 18b mit der Oberfläche des Aktuators 11 durch eine Klebeverbindung 15 verbunden.

Der jeweilige Teilbereich 17a, 17b ist von der Oberfläche des Aktuators 11 beabstandet. Insbesondere befindet sich zwischen dem jeweiligen Teilbereich 17a, 17b und der Unterseite 26 bzw. der Oberseite 25 des Aktuators 11 ein Freibereich 16. Der Freibereich 16 weist eine Höhe h auf. Eine freie Höhe h zwischen dem Aktuator 11 und dem Teilbereich 17a, 17b liegt zwischen 0,2 mm und 2,0 und beträgt in dem ersten Ausführungsbeispiel 0,75 mm und in dem zweiten Ausführungsbeispiel 0,4 mm, wobei die freie Höhe h den maximalen Abstand zwischen dem Teilbereich 17a, 17b und dem piezoelektrischen Aktuator 11 angibt, wenn keine Spannung an dem Aktuator 11 anliegt und keine äußere Kraft auf das Verstärkungselement 13a, 13b wirkt.

Die Höhe h des Freibereichs 16 variiert entlang des jeweiligen Teilbereichs 17a, 17b. So ist der mittlere Bereich 19a, 19b des jeweiligen Teilbereichs 17a, 17b so ausgebildet, dass er parallel zu der Oberfläche des Aktuators 11 verläuft. Damit ist die Höhe h des Freibereichs 16 im Bereich des mittleren Bereichs 19a, 19b maximal. Der jeweilige Verbindungsbereich 20a, 20b verläuft hingegen schräg zur Oberfläche des Aktuators 11. Mit anderen Worten der jeweilige Verbindungsbereich 20a, 20b schließt einen Winkel mit der Oberseite 25 bzw. der Unterseite 26 des Aktuators 11 ein. Der Winkel ist vorzugsweise kleiner oder gleich 45°. Damit verkleinert sich die Höhe h des Freibereichs 16 in Richtung von mittleren Bereich 19a, 19b hin zum Endbereich 18a, 18b des jeweiligen Verstärkungselements 13a, 13b. Folglich weist das jeweilige Verstärkungselement 13a, 13b eine gebogene Form auf.

Das jeweilige Verstärkungselement 13a, 13b kann in alternativen, hier nicht gezeigten Ausführungsformen wenigstes eine Ausdünnung, vorzugsweise mehrere Ausdünnungen, zwischen den jeweiligen Bereichen des Verstärkungselements aufweisen.

Bei den mechanischen Verstärkungselementen 13a, 13b kann es sich jeweils um ein Titanblech handeln, das eine Dicke zwischen 0,1 mm und 0,4 mm aufweist. Beispielsweise kann das Blech eine Dicke von 0,2 mm aufweisen. Bei Blechdicken in dem hier genannten Bereich kann eine Verformung des Blechs, die zur Ausführung einer Hubbewegung erforderlich ist, mit einer geringen Kraft herbeigeführt werden. Es kann daher darauf verzichtet werden, die Verformbarkeit des Blechs durch Ausdünnungen zu erhöhen. Dementsprechend kann das Blech frei von Ausdünnungen oder Einkerbungen sein.

Der flache mittlere Bereich 19a, 19b des jeweiligen Verstärkungselementes 13a, 13b kann eine Länge zwischen 1,5 mm und 5,0 mm aufweisen. Im ersten Ausführungsbeispiel ist der mittlere Bereich 19a, 19b 3,5 mm lang. Im zweiten Ausführungsbeispiel 19a, 19b ist der mittlere Bereich 2,5 mm lang. Die Endbereiche 18a, 18b können eine Länge zwischen 1,0 mm und 0,5 mm aufweisen. Im ersten und im zweiten Ausführungsbeispiel sind die Endbereiche 18a, 18b jeweils 0,7 mm lang. Eine geringere Länge als 0,5 mm sollte nicht gewählt werden, da ansonsten die Klebeverbindung 15 zwischen den Endbereichen 18a, 18b und dem Aktuator 11 möglicherweise nicht ausreichend stark ausgebildet werden kann.

Eine Gesamthöhe des Bauteils bestehend aus dem Aktuator 11 und den beiden Verstärkungselementen 13a, 13b kann zwischen 5,0 mm und 1,0 mm liegen. In dem ersten Ausführungsbeispiel beträgt die Gesamthöhe 2,4 mm. In dem zweiten Ausführungsbeispiel beträgt die Gesamthöhe 1,7 mm.

Für den Einsatz des Bauteils in elektronischen Geräten und auch in anderen Geräten ist Miniaturisierung ein wesentlicher Gesichtspunkt. Durch die Verwendung der hier beschriebenen Bauteile mit den angegebenen Dimensionen werden Bauteile bereitgestellt, die ein haptisches Signal erzeugen und dabei nur einen sehr geringen Platzbedarf aufweisen. Ein Bauteil mit den oben angegebenen Dimensionen kann beispielsweise unter einem Knopf an der Seitenwand eines Mobiltelefons oder eines Uhrengehäuses platziert werden.

Bei einer angelegten Spannung von 60 V ergibt sich in dem ersten Ausführungsbeispiel eine freie Auslenkung, beziehungsweise ein Hub, von 25 $\mu$m und eine Blockierkraft von 3,5 N. Die Steifigkeit beträgt dabei 0,14 N/pm. Im zweiten Ausführungsbeispiel ergibt sich bei einer angelegten Spannung von 60 V eine freie Auslenkung, beziehungsweise ein Hub, von 15 $\mu$m und eine Blockierkraft von 2,5 N. Die Steifigkeit beträgt dabei 0,16 N/pm.

Wird nun an den Aktuator 11 Spannung angelegt, so bewegen sich die Teilbereiche 17a, 17b des jeweiligen Verstärkungselements 13a, 13b relativ zum Aktuator 11 in eine zweite Richtung R2. Die zweite Richtung R2 ist senkrecht zur ersten Richtung R1. Die zweite Richtung R2 verläuft entlang der Stapelrichtung S.

Insbesondere bewegen sich die mittleren Bereiche 19a, 19b in die zweite Richtung R2. Dabei biegt sich das jeweilige Verstärkungselement 13a, 13b an Übergängen zwischen mittlerem Bereich 19a, 19b und Verbindungsbereichen 20a, 20b sowie zwischen Verbindungsbereichen 20a, 20b und Endbereichen 18a, 18b.

Hingegen wird eine Bewegung der Endbereiche 18a, 18b in die zweite Richtung R2 durch die Klebeverbindung 15 mit dem Aktuator 11 verhindert. Vielmehr bewegen sich die Endbereiche 18a, 18b mit dem Aktuator 11 in die erste Richtung R1. Es findet damit eine Relativbewegung zwischen den Endbereichen 18a, 18b und den Teilbereichen 17a, 17b statt.

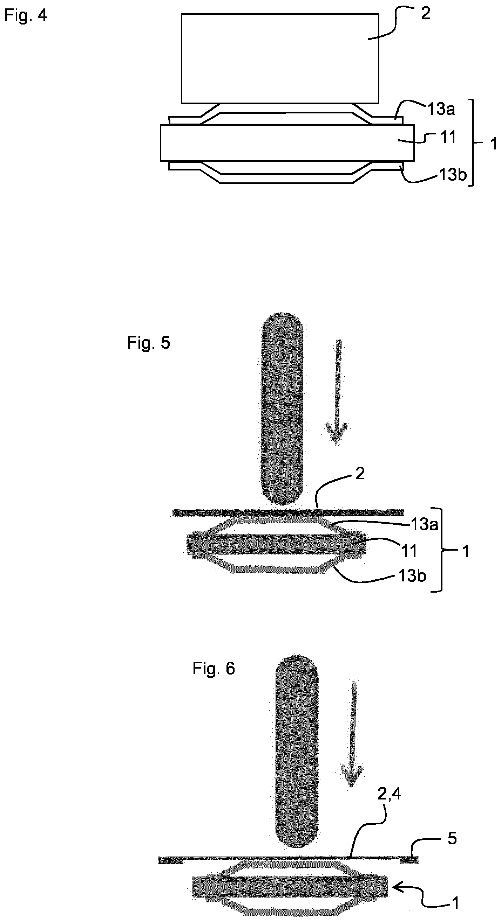

Figur 4 zeigt schematisch ein Anordnung, bei der ein Bauteil 1 zur Erzeugung eines haptischen Signals, das den piezoelektrischen Aktuator 11 und die Verstärkungselemente 13a, 13b aufweist, unter einem Bedienelement 2 angeordnet ist.

Die Anordnung kann beispielsweise in einem elektronischen Gerät verwendet werden, das eine Gehäusewand 3 aufweist. In der Gehäusewand 3 ist das Bedienelement 2 angeordnet. Bei dem Bedienelement 2 handelt es sich um einen Knopf. Das Bedienelement 2 kann von einem Nutzer des elektronischen Geräts durch Drücken betätigt werden. Das Bauteil 1 aufweisend den piezoelektrischen Aktuator 11 und die beiden Verstärkungselemente 13a, 13b ist unmittelbar unter dem Bedienelement 2 angeordnet. Dabei liegt das auf der Oberseite 25 des piezoelektrischen Aktuators 11 angeordnete Verstärkungselement 13a unmittelbar an dem Bedienelement 2 an.

Wird das Bedienelement 2 gedrückt, übt das Bedienelement 2 eine Kraft auf das Verstärkungselement 13a aus. Durch die auf das Verstärkungselement 13a ausgeübte Kraft wird dieses verformt, wobei insbesondere die Endbereiche 18a, 18b in der ersten Richtung R1 voneinander wegbewegt werden. Das Verstärkungselement 13a ist derart an dem piezoelektrischen Aktuator 11 befestigt, dass durch die auf das Verstärkungselement 13a ausgeübte Kraft und die damit verbundene Verformung des Verstärkungselements 13a auch der piezoelektrische Aktuator 11 in Längsrichtung verformt wird. Dadurch wird in dem piezoelektrischen Aktuator 11 eine Spannung erzeugt. Diese Spannung kann detektiert werden und auf diese Weise kann auf eine Betätigung des Bedienelements 2 rückgeschlossen werden. Dazu kann der piezoelektrische Aktuator 11 mit einem Mikrocontroller verbunden sein, der die am piezoelektrischen Aktuator 11 erzeugten Spannungen auswertet. Der piezoelektrische Aktuator 11 kann in dem elektrischen Gerät somit als Sensor eingesetzt werden, der die Betätigung des Bedienelements 2 erkennt.

Darüber hinaus kann der piezoelektrische Aktuator 11 auch zur Erzeugung eines haptischen Signals eingesetzt werden. Wird eine elektrische Spannung an den Aktuator 11 angelegt, so verformt sich der Aktuator 11 in Längsrichtung und das Verstärkungselement 13a führt dementsprechend eine Hubbewegung aus. Auf Grund der Anordnung des Bauteils 1 direkt unter dem Bedienelement 2, führt das Bedienelement 2 ebenfalls die Hubbewegung aus, wenn das Verstärkungselement 13a die Hubbewegung ausführt. Dadurch kann eine Vibration des Bedienelements 2 erzeugt werden, die als haptisches Signal an dem Bedienelement 2 für den Nutzer wahrnehmbar ist. Beispielsweise kann dieses haptische Signal als haptische Rückmeldung eingesetzt werden, die dem Nutzer eine Betätigung des Bedienelementes 2 bestätigt.

Figur 5 zeigt einen Teil eines weiteren Gerätes in schematischer Ansicht. In dem in Figur 5 gezeigten Ausführungsbeispiel ist das Bauteil 1 aufweisend den piezoelektrischen Aktuator 11 und die Verstärkungselemente 13a, 13b unter einem Bedienelement 2 des elektronischen Gerätes angeordnet. Bei dem Bedienelement 2 handelt es sich um einen Bereich 4 der Gehäusewand.

Durch die Anordnung des piezoelektrischen Aktuators unter der Gehäusewand wird es ermöglicht, die Gehäusewand selbst als Bedienelement zu verwenden. Wird die Gehäusewand wie in Figur 5 angedeutet durch einen Finger oder einen Stift gedrückt, verformt sich die Gehäusewand. Dadurch wird der unmittelbar unter der Gehäusewand angeordnete Aktuator ebenfalls verformt und die Betätigung der Gehäusewand kann in analoger Weise zu dem in Figur 4 beschriebenen Ausführungsbeispiel erkannt werden.

Der piezoelektrische Aktuator 11 kann ferner dazu eingesetzt werden, den Bereich 4 der Gehäusewand 3, der als Bedienelement 2 verwendet wird, in eine Vibration zu versetzen und auf diese Weise ein haptisches Signal zu erzeugen.

Wird die Gehäusewand 3 selbst als Bedienelement 2 verwendet, ergibt sich der Vorteil, dass auf Dichtungen verzichtet werden kann, die andernfalls oft erforderlich sind, um ein in der Gehäusewand 3 angeordnetes Bedienelement 2 derart zu konstruieren, dass das Gehäuseinnere vor Staub, Schmutz und Wasser geschützt ist.

Ein konventionelles Bedienelement 2, wie z.B. Taster der in Figur 4 gezeigte Knopf, hat in der Regel eine geringe Masse von einigen Gramm. Das Bedienelement 2 und das Bauteil 1 bilden zusammen, vereinfacht, ein Feder-Masse-System. Die Resonanzfrequenz $f_0$ (= Eigenfrequenz/freie Schwingung des Feder-Masse-Systems bei einmaliger Anregung) ergibt sich zu:

$$f_0 = \frac{1}{2\,\pi}\sqrt{\frac{D}{m}}$$ , wobei **D** die Steifigkeit und **m** die Masse des Systems ist.

Soll die Bedienung, wie oben erwähnt, direkt über die Gehäusewand 3 erfolgen, muss das Gesamtsystem aus Bauteil 1 und Gehäuse betrachtet werden. In diesem Fall ist die Beschreibung komplizierter, da die Resonanzfrequenz in hohem Maße von der Integration des Bauteils 1 in das Gehäuse abhängt. Hier gilt es sicher zu stellen, dass nicht das ganze Gehäuse schwingt, sondern möglichst nur der Bereich 3 der Gehäusewand über dem Bauteil 1.

Figur 6 zeigt ein Gerät gemäß einer weiteren Ausführungsform. Im Vergleich zu der in Figur 5 gezeigten Ausführungsform wurde die Gehäusewand 3 in dem Bereich 4, der als Bedienelement 2 verwendet wird, mit einer geringeren Wandstärke gefertigt, als in den Bereichen 5, die nicht als Bedienelement 2 verwendet werden. Durch die geringere Wandstärke der Gehäusewand 3 in dem Bereich 4, der als Bedienelement 2 dient, kann eine bessere Druckübertragung von der Gehäusewand 3 auf den Aktuator 11 ermöglicht werden. Außerdem weist der Bereich 4 der Gehäusewand 3 auf Grund seiner reduzierten Dicke eine größere mechanische Verformbarkeit auf als in dem in Figur 5 gezeigten Gerät. Daher kann der Bereich 4 durch den Aktuator 11 in eine stärkere Vibration versetzt werden, sodass eine stärkeres haptisches Signal erzeugt wird. Darüber hinaus kann durch die unterschiedliche Dicke der Bereiche 4, 5 der Gehäusewand 3 sichergestellt werden, dass die Bereiche 5 der Gehäusewand 3, die nicht als Bedienelement 2 dienen, nicht in Vibration versetzt werden, sondern die Vibration lokal begrenzt bleibt. Die dünnere Ausgestaltung des Bereichs 4 ermöglicht es somit, den Bereich 4 von den übrigen Bereichen 5 der Gehäusewand hinsichtlich der Vibration zu isolieren.

Alternativ oder ergänzend kann der Bereich 4 der Gehäusewand 3, der als Bedienelement 2 dient, von den übrigen Bereichen 5 der Gehäusewand 3 durch eine oder mehrere Kerben abgetrennt sein. Auch dadurch kann eine lokale Begrenzung der Vibration herbeigeführt werden.

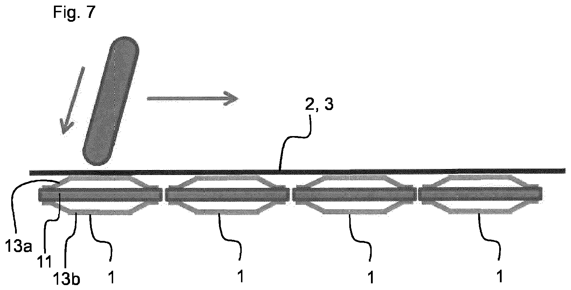

Figur 7 zeigt eine Anordnung gemäß einer weiteren Ausführungsform. Auch in dieser Ausführungsform wird ein Bereich 4 der Gehäusewand 3 als Bedienelement 2 verwendet. Unter dem Bereich der Gehäusewand sind mehrere Bauteile 1 zur Erzeugung eines haptischen Signals angeordnet, die zu einem Array angeordnet sind.

Die mechanischen Verstärkungselemente 13a, die auf der Oberseite 25 des jeweiligen Aktuators 11 angeordnet sind, liegen dabei an einer Innenseite der Gehäusewand 3 an. Jeder der piezoelektrischen Aktuatoren 11 in dem Array kann separat angesteuert werden und separat ausgelesen werden. Dadurch kann es ermöglicht werden, nicht nur eine Betätigung des Bedienelementes 2 zu erkennen, sondern auch zu erkennen, an welcher Position das Bedienelement 2 betätigt wird. Dadurch kann die Erkennung einer Gestensteuerung ermöglicht werden. Beispielsweise kann es erkannt werden, wenn mit einem Finger oder einem Stift über das Bedienelement 2 gestrichen wird. Insbesondere kann dabei die Richtung der Bedienung und die Geschwindigkeit der Bedienung erkannt werden.

Wenn der Anwender nun mittels Gestensteuerung das Gerät bedient, zum Beispiel indem der Anwender einen Finger oder einen Stift über den als Bedienelement 2 vorgesehenen Bereich 4 der Gehäusewand 3 über den Aktuatoren 11 bewegt, liegt an jedem Aktuator 11 ein unterschiedliches Druckprofil und somit eine unterschiedliche elektrische Spannung abhängig von der jeweiligen Druckkraft und der Bewegungsgeschwindigkeit an. Diese Signale können von einem Mikrocontroller, der mit den Aktuatoren 11 verbunden ist, in die entsprechenden Gesten umgerechnet werden.

Beispielsweise können die Aktuatoren 11 unter der seitlichen Gehäusewand 3 eines elektronischen Gerätes verbaut sein und die Lauter/Leiser-Taste ersetzen. Ein Streichen in eine Richtung kann mit der Funktion "lauter" gleichgesetzt sein und ein Streichen in die entgegengesetzte Richtung kann mit der Funktion "leiser" gleichgesetzt sein.

Die Verwendung des Arrays von piezoelektrischen Aktuatoren 11 ermöglicht es darüber hinaus, lokal auf dem Bedienelement 2 an verschiedenen Positionen ein haptisches Signal zu erzeugen. Durch die mehreren piezoelektrischen Aktuatoren 11 kann ein haptisches Signal mit unterschiedlicher Intensität erzeugt werden, abhängig davon, wie viele der Aktuatoren 11 für die Erzeugung des haptischen Signals verwendet werden. Dadurch kann es beispielsweise ermöglicht werden, die Intensität des haptischen Signals derart anzupassen, dass sie dem Nutzer Informationen bezüglich einer Lautstärke gibt, zum Beispiel kann die Intensität des haptischen Signals proportional zu einer Musiklautstärke sein.

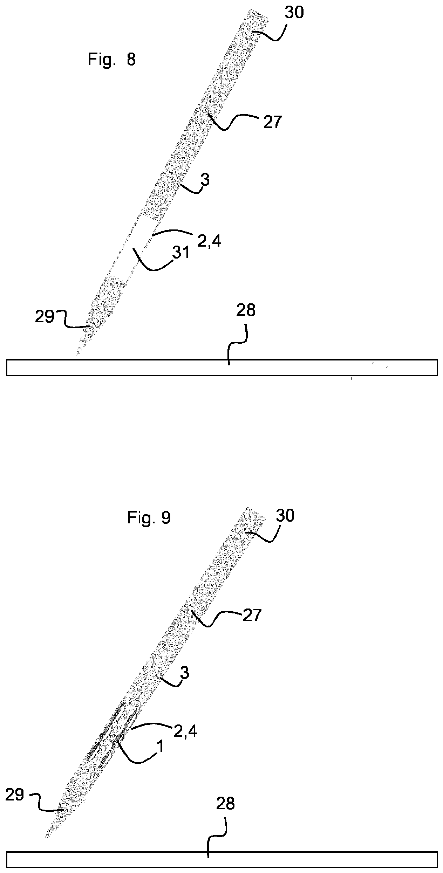

Figur 8 zeigt einen Stylus 27, der die oben beschriebene Anordnung aufweist. Bei dem Stylus 27 handelt es sich um ein stiftförmiges Eingabe- und/oder Ausgabegerät. Der Stylus 27 kann insbesondere als stiftförmiges Eingabe- und/oder Ausgabegerät für eine Bedienoberfläche 28 verwendet werden. Bei der Bedienoberfläche 28 kann es sich beispielsweise um einen Bildschirm eines Mobiltelefons oder eines Tablets handeln. Es kann sich bei der Bedienoberfläche 28 auch um eine berührungsempfindliche Fläche eines Küchengeräts, beispielsweise eines Herds, oder eines medizinischen Geräts, beispielsweise eines Operationstisches, handeln. Es kann sich bei der Bedienoberfläche 28 auch um eine Platte, beispielsweise eine Tischplatte oder eine Glasplatte, handeln. Die Platte kann dabei im Rahmen einer Augmented Reality Anwendung eingesetzt werden. Ferner kann es sich bei der Bedienoberfläche 28 auch um eine virtuelle Fläche handeln.

Der Stylus 27 weist die oben beschriebene Anordnung auf, die es ermöglicht, ein haptisches Signal an den Nutzer zu senden. Zur Erzeugung des haptischen Signals wird entweder eine Tastspitze 29 oder ein Bereich eines Grundkörpers 30 des Stylus 27 in eine Vibration versetzt. Dadurch kann bei dem Nutzer ein haptischer Eindruck erzeugt werden. Beispielsweise kann bei dem Nutzer der Eindruck erzeugt werden, dass der Stylus 27 über eine Oberfläche bewegt würde. Dazu weist der Stylus 27 die oben beschriebene Anordnung mit zumindest einem Bauteil 1 zur Erzeugung eines haptischen Signals auf, das dazu ausgestaltet ist, Vibrationen zu erzeugen, durch die dem Nutzer der haptische Eindruck einer Bewegung des Stylus 27 über die Oberfläche vermittelt wird.

Der Stylus 27 kann in zwei unterschiedlichen Betriebsmodi verwendet werden. Der erste Betriebsmodus wird auch als "Wiedergabemodus" bezeichnet. Dabei wird der piezoelektrische Aktuator 11 zur Erzeugung einer Vibration verwendet, die einem Nutzer einen haptischen Eindruck vermittelt. Der zweite Betriebsmodus wird auch als "Einlesemodus" bezeichnet. Dabei wird der Stylus 27 entlang einer Oberfläche geführt. Die von der Oberfläche dabei auf den Stylus 27 ausgeübte Kraft wird von dem Stylus 27, insbesondere von dem piezoelektrischen Aktuator 11 bzw. einer damit verbundenen Elektronik, erkannt und ein daraus berechnetes Oberflächenprofil wird abgespeichert. Im "Wiedergabemodus" kann ein haptisches Signal erzeugt werden, das beispielsweise das im "Einlesemodus" abgespeicherte Oberflächenprofil wiedergibt.

Der in Figur 8 gezeigte Stylus 27 weist eine Einheit 31 aufweisend ein Bauteil 1 zur Erzeugung eines haptischen Signals, das einen piezoelektrischen Aktuator 11 aufweist, und ein Bedienelement 2 auf. Zur besseren Veranschaulichung ist das Bauteil 1 in Figur 8 nicht eingezeichnet. Es handelt sich bei dem Bedienelement 2 um einen Bereich 4 einer Gehäusewand 3 des Stylus 27. Soll ein haptisches Signal erzeugt werden, kann der piezoelektrische Aktuator 11 hierzu einen Bereich 4 der Gehäusewand 3 in Vibration versetzen.

Ferner weist der Stylus 27 die Tastspitze 29 auf. Die Tastspitze 29 ist an einem Schreib-Ende des Stylus 27 angeordnet, das bei Benutzung des Stylus 27 zu der Bedienoberfläche 28 weist. Die Tastspitze 29 kann eine Abtasteinheit ausbilden. In der Tastspitze 29 können ein Annäherungssensor und/oder andere elektronische Komponenten angeordnet sein.

Ferner weist der Stylus 27 den Grundkörper 30 auf. In dem Grundkörper 30 ist die Anordnung untergebracht. Ferner können in dem Grundkörper 30 eine Ansteuerelektronik, eine Energieversorgung und diverse Sensoren angeordnet sein. Die Sensoren können dabei beispielsweise einen Beschleunigungssensor und/oder einen Wegsensor und/oder einen Annäherungssensor umfassen. Die Ansteuerelektronik kann dazu ausgestaltet sein, den piezoelektrischen Aktuator 11 anzusteuern. Dabei kann ein von der Ansteuerelektronik an den piezoelektrischen Aktuator 11 angelegtes Signal unter Berücksichtigung von Messdaten, die von den Sensoren ermittelt werden, angepasst werden.

Figur 9 zeigt den Stylus 27 gemäß einem zweiten Ausführungsbeispiel. In dem zweiten Ausführungsbeispiel weist der Stylus 27 mehrere Bauteile 1 zur Erzeugung eines haptischen Signals auf. Die Bauteile 1 sind jeweils in dem Grundkörper 30 des Stylus 27 angeordnet. Die Bauteile 1 sind nahe der Gehäusewand 3 des Stylus 27 angeordnet. Die weiteren Merkmale des Stylus 27 gemäß dem zweiten Ausführungsbeispiel stimmen mit dem in Figur 8 gezeigten Stylus 27 überein.

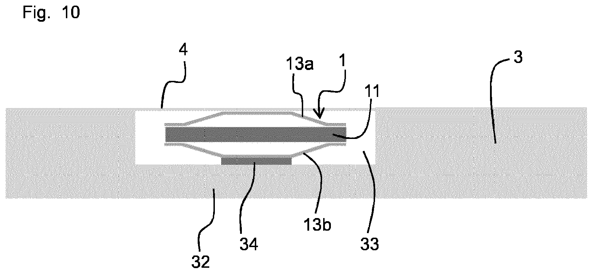

Figur 10 zeigt ein weiteres Ausführungsbeispiel.

Das Bauteil 1 zur Erzeugung des haptischen Signals ist zwischen einem Bedienelement 2 und einer Rückwand 32 eingeklemmt. Das Bedienelement 2 wird dabei von einem Bereich 4 einer Gehäusewand 3 gebildet. Die Rückwand 32 wird von einem weiteren Bereich der Gehäusewand 3 gebildet. Die Rückwand 32 und das Bedienelement 2 können auch durch miteinander verschraubte oder anders fest miteinander verbundene Gehäuseteile gebildet werden.

Zwischen dem Bedienelement 2 und der Rückwand 32 ist ein Hohlraum 33 angeordnet. In dem Hohlraum 33 ist das Bauteil 1 zur Erzeugung des haptischen Signals angeordnet. Das Bauteil 1 weist den piezoelektrischen Aktuator 11 und zwei Verstärkungselemente 13a, 13b auf. Eines der Verstärkungselemente 13b ist mit der Rückwand 32 durch eine Klebeschicht 34 verklebt.

Das Bedienelement 2 ist eine spaltenlose Bedienoberfläche. Die Bedienoberfläche ist für einen Benutzer sichtbar und bedienbar. Auf der Bedienoberfläche kann ein Symbol angeordnet sein, das auf eine bestimmte Bedienfunktion hinweist, beispielsweise das Erhöhen oder Verringern einer Lautstärke.

Typischerweise ist die Steifigkeit der Rückwand 32 sehr viel größer als die Steifigkeit des piezoelektrischen Aktuators 11. Die Steifigkeit des Aktuators 11 ist wiederrum größer als die des Bedienelements 2, das hier durch eine Dünnstelle des Gehäuses gebildet wird, die auch als Membran bezeichnet werden könnte. Ein typischer Wert der Steifigkeit der Membran liegt im Bereich von 1% - 50% der Steifigkeit des Aktuators 11.

Der obengenannte Aufbau stellt sicher, dass ausschließlich die Dünnstelle verformt wird und damit die Stärke der haptischen Rückmeldung für den Benutzer maximiert wird. Zusätzlich kann eine Federwirkung der Dünnstelle durch Variation der Dicke oder der Verbindung zwischen Dünnstelle und Rückwand 32 optimiert werden.

Bezugszeichenliste

| 1 | Bauteil |
|---|---|
| 2 | Bedienelement |
| 3 | Gehäusewand |
| 4 | Bereich der Gehäusewand |
| 5 | Bereich der Gehäusewand |
| 11 | Piezoelektrischen Aktuator |
| 12 | Isolationsbereich |
| 13a | Verstärkungselement |
| 13b | Verstärkungselement |
| 15 | Klebeverbindung |
| 16 | Freibereich |
| 17a, 17b | Teilbereich |
| 18a, 18b | Endbereich |
| 19a, 19b | Erster Abschnitt des Teilbereichs / mittlerer Bereich |
| 20a, 20b | Zweiter Abschnitt des Teilbereichs / Verbindungsbereich |
| 21 | Innenelektrode |
| 22 | Piezoelektrische Schicht |
| 23 | Außenelektrode |
| 24 | Stirnfläche |
| 25 | Oberseite |
| 26 | Unterseite |
| 27 | Stylus |
| 28 | Bedienoberfläche |
| 29 | Tastspitze |
| 30 | Grundkörper |
| 31 | Einheit |
| 32 | Rückwand |
| 33 | Hohlraum |
| 34 | Klebeschicht |
| B | Breite des Aktuators |
| h | Höhe des Freibereichs |
| H | Höhe des Aktuators |
| L | Länge des Aktuators |
| R1 | Erste Richtung |
| R2 | Zweite Richtung |
| S | Stapelrichtung |

**Patentansprüche**

1.  Anordnung,

aufweisend ein Bedienelement (2) und ein Bauteil (1) zur Erzeugung eines haptischen Signals, das einen piezoelektrischen Aktuator (11) aufweist,
wobei das Bauteil (1) unter dem Bedienelement (2) angeordnet ist und dazu ausgestaltet ist, an dem Bedienelement (2) eine Vibration zu erzeugen, wobei es sich bei dem Bedienelement (2) um einen Bereich (4) einer Gehäusewand (3) handelt,

wobei die Gehäusewand (3) in dem Bereich (4), der als Bedienelement (2) dient, eine größere mechanische Verformbarkeit aufweist als in anderen Bereichen (5).

2. Anordnung gemäß dem vorherigen Anspruch, wobei das Bedienelement (2) und das Bauteil (1) zur Erzeugung eines haptischen Signals eine Einheit bilden.

3. Anordnung gemäß einem der vorherigen Ansprüche, wobei der piezoelektrische Aktuator (11) dazu ausgestaltet ist, in Folge einer Betätigung des Bedienelements (2) verformt zu werden und dabei die Betätigung des Bedienelements (2) zu detektieren.

4. Anordnung gemäß einem der vorherigen Ansprüche,

   wobei die Gehäusewand in dem Bereich (4), der als Bedienelement (2) dient, dünner ist als in einem anderen Bereich, und/oder wobei der Bereich (4) der Gehäusewand, der als Bedienelement (2) dient, von den übrigen Bereichen (5) der Gehäusewand durch zumindest eine Kerbe getrennt ist.

5. Anordnung gemäß einem der vorherigen Ansprüche, wobei auf dem Bereich (4) der Gehäusewand (3), der das Bedienelement (2) bildet, ein Symbol angeordnet ist, das auf eine Bedienungsfunktion hinweist.

6. Anordnung gemäß einem der vorherigen Ansprüche, wobei das Bauteil (1) zur Erzeugung eines haptischen Signals zwischen dem Bedienelement (2) und einer Rückwand (32) eingeklemmt ist.

7. Anordnung gemäß dem vorherigen Anspruch,

   wobei eine Steifigkeit der Rückwand (32) größer ist als eine Steifigkeit des piezoelektrischen Aktuators (11), und/oder wobei eine Steifigkeit des piezoelektrischen Aktuators (11) größer ist als eine Steifigkeit des Bedienelements (2) .

8. Anordnung gemäß einem der Ansprüche 6 oder 7, wobei das Bedienelement (1) und die Rückwand (32) fest miteinander verbunden sind.

9. Anordnung gemäß einem der Ansprüche 6 bis 8, wobei das Bauteil (1) zur Erzeugung eines haptischen Signals an dem Bedienelement (2) und/oder an der Rückwand (32) befestigt ist.

10. Anordnung gemäß einem der vorherigen Ansprüche, wobei das Bauteil (1) ein mechanisches Verstärkungselement (13a, 13b) aufweist, das an dem piezoelektrischen Aktuator (11) derart befestigt ist, dass durch eine Längenänderung des piezoelektrischen Aktuators (11) in seine Längsrichtung ein Bereich (19a, 19b) des mechanischen Verstärkungselements in eine zu der Längsrichtung senkrechten Richtung bewegt wird.

11. Anordnung gemäß dem vorherigen Anspruch, wobei das mechanische Verstärkungselement (13a, 13b) ein Metallbügel ist.

12. Anordnung gemäß einem der Ansprüche 10 oder 11,

   wobei das mechanische Verstärkungselement (13a, 13b) frei von Einkerbungen ist und eine konstante Wandstärke aufweist, oder wobei das mechanische Verstärkungselement (13a, 13b) zumindest eine Einkerbung aufweist, die einen mechanischen Widerstand gegen eine Verformung des mechanischen Verstärkungselements reduziert.

13. Anordnung gemäß einem der vorherigen Ansprüche, aufweisend mehrere Bauteile (1) zur Erzeugung eines haptischen Signals, die jeweils einen piezoelektrischen Aktuator (11) aufweisen und die nebeneinander als Array angeordnet sind.

14. Anordnung gemäß dem vorherigen Anspruch, wobei jeder der piezoelektrischen Aktuatoren (11) separat von den übrigen piezoelektrischen Aktuatoren (11) ausgelesen und angesteuert werden kann.

15. Anordnung gemäß einem der Ansprüche 13 oder 14, wobei das Array von Bauteilen (1) dazu ausgestaltet ist, eine Gestensteuerung des Bedienelements (2) zu erkennen, wobei das elektronische Gerät ferner eine Auswerteeinheit aufweist, die dazu ausgestaltet ist, an jedem der piezoelektrischen Aktuatoren (11) die erzeugte elektrische Spannung auszulesen, aus der an den Aktuatoren (11) erzeugten Spannung auf das an dem jeweiligen Aktuator (11) anliegende Druckprofil zu schließen und die Druckprofile in Gesten der Gestensteuerung umzurechnen.

16. Anordnung, aufweisend

   eine Gehäusewand (3), die einen Bereich (4) aufweist, der zur Verwendung als Bedienelement ausgestaltet ist, und mehrere Bauteile (1) zur Erzeugung eines haptischen Signals, die jeweils einen piezoelektrischen Aktuator (11) aufweisen, wobei die Bauteile (1) nebeneinander zu einem Array angeordnet sind und wobei die Bauteile (1) unter dem Bereich (4) der Gehäusewand (3) angeordnet sind, wobei die Gehäusewand (3) in dem Bereich (4), der als Bedienelement (2) dient, eine größere mechanische Verformbarkeit aufweist als in anderen Bereichen (5), und

eine Auswerteeinheit, die dazu ausgestaltet ist, an jedem der piezoelektrischen Aktuatoren (11) die erzeugte elektrische Spannung auszulesen und aus der an den Aktuatoren (11) erzeugten Spannung auf das an dem jeweiligen Aktuator (11) anliegende Druckprofil zu schließen.

**17.** Anordnung gemäß dem vorherigen Anspruch, wobei jeder der piezoelektrischen Aktuatoren (11) separat von den übrigen piezoelektrischen Aktuatoren (11) ausgelesen und angesteuert werden kann.

**18.** Anordnung gemäß einem der Ansprüche 16 oder 17, wobei die Auswerteeinheit dazu ausgestaltet ist, die Druckprofile in Gesten einer Gestensteuerung umzurechnen.

**19.** Medizinisches Gerät aufweisend eine Anordnung gemäß einem der vorherigen Ansprüche.

**20.** Maschine für einen industriellen Einsatz aufweisend eine Anordnung gemäß einem der Ansprüche 1 bis 18.

**21.** Küchengerät aufweisend eine Anordnung gemäß einem der Ansprüche 1 bis 18.

**22.** Elektronisches Verdampfungsgerät aufweisend eine Anordnung gemäß einem der Ansprüche 1 bis 18.

**23.** Elektronisches Gerät aufweisend eine Anordnung gemäß einem der Ansprüche 1 bis 18.

**24.** Elektronisches Gerät gemäß dem vorherigen Anspruch, wobei es sich bei dem elektronischen Gerät um ein Mobiltelefon, ein Tablet, ein Laptop, eine Smartwatch oder ein Fitness-, Herzraten-, Schlaf- oder Gesundheitstracker handelt.

**25.** Stylus aufweisend eine Anordnung gemäß einem der Ansprüche 1 bis 18.

**26.** Stylus gemäß dem vorherigen Anspruch, wobei das Bauteil (1) zur Erzeugung des haptischen Signals eine Tastspitze des Stylus in Vibration versetzt oder wobei das Bauteil (1) zur Erzeugung des haptischen Signals einen Bereich eines Gehäuses des Stylus in Vibration versetzt.

**Claims**

**1.** Arrangement,

having an operator control element (2) and a component (1) for generating a haptic signal, which component has a piezoelectric actuator (11),
wherein the component (1) is arranged below the operator control element (2) and is designed to generate a vibration on the operator control element (2), wherein the operator control element (2) is a region (4) of a housing wall (3), wherein the housing wall (3) has a greater degree of mechanical deformability in the region (4) which serves as the operator control element (2) than in other regions (5) .

**2.** Arrangement according to the preceding claim, wherein the operator control element (2) and the component (1) for generating a haptic signal form a unit.

**3.** Arrangement according to either of the preceding claims,
wherein the piezoelectric actuator (11) is designed to be deformed as a result of operation of the operator control element (2) and in the process to detect operation of the operator control element (2).

**4.** Arrangement according to one of the preceding claims,

wherein the housing wall is thinner in the region (4) which serves as the operator control element (2) than in another region,
and/or
wherein that region (4) of the housing wall which serves as the operator control element (2) is separated from the other regions (5) of the housing wall by at least one notch.

**5.** Arrangement according to one of the preceding claims,
wherein a symbol which indicates an operator control function is arranged on that region (4) of the housing wall (3) which forms the operator control element (2).

**6.** Arrangement according to one of the preceding claims,
wherein the component (1) for generating a haptic signal is clamped in between the operator control element (2) and a rear wall (32).

**7.** Arrangement according to the preceding claim,

wherein a stiffness of the rear wall (32) is greater than a stiffness of the piezoelectric actuator (11),

and/or
wherein a stiffness of the piezoelectric actuator (11) is greater than a stiffness of the operator control element (2).

8. Arrangement according to either of Claims 6 and 7, wherein the operator control element (1) and the rear wall (32) are fixedly connected to one another.

9. Arrangement according to one of Claims 6 to 8, wherein the component (1) for generating a haptic signal is fastened to the operator control element (2) and/or to the rear wall (32).

10. Arrangement according to one of the preceding claims,
wherein the component (1) has a mechanical reinforcement element (13a, 13b) which is fastened to the piezoelectric actuator (11) in such a way that a region (19a, 19b) of the mechanical reinforcement element is moved in a direction which is perpendicular to the longitudinal direction owing to a change in length of the piezoelectric actuator (11) in its longitudinal direction.

11. Arrangement according to the preceding claim, wherein the mechanical reinforcement element (13a, 13b) is a metal bracket.

12. Arrangement according to either of Claims 10 and 11,

wherein the mechanical reinforcement element (13a, 13b) is free of indentations and has a constant wall thickness,
or
wherein the mechanical reinforcement element (13a, 13b) has at least one indentation which reduces mechanical resistance to deformation of the mechanical reinforcement element.

13. Arrangement according to one of the preceding claims,
having a plurality of components (1) for generating a haptic signal, which components each have a piezoelectric actuator (11) and which components are arranged next to one another in the form of an array.

14. Arrangement according to the preceding claim, wherein each of the piezoelectric actuators (11) can be read out and driven separately from the other piezoelectric actuators (11).

15. Arrangement according to either of Claims 13 and 14,

wherein the array of components (1) is designed to identify a gesture control operation of the operator control element (2),
wherein the electronic device further has an evaluation unit which is designed to read out the generated electrical voltage from each of the piezoelectric actuators (11), to draw a conclusion about the pressure profile which is applied to the respective actuator (11) from the voltage which is generated on the actuators (11) and to convert the pressure profiles into gestures of the gesture control operation.

16. Arrangement having

a housing wall (3) which has a region (4) which is designed for use as an operator control element,
and a plurality of components (1) for generating a haptic signal, which components each have a piezoelectric actuator (11), wherein the components (1) are arranged next to one another to form an array and wherein the components (1) are arranged below the region (4) of the housing wall (3), wherein the housing wall (3) has a greater degree of mechanical deformability in the region (4) which serves as the operator control element (2) than in other regions (5),
and
an evaluation unit which is designed to read out the generated electrical voltage from each of the piezoelectric actuators (11) and to draw a conclusion about the pressure profile which is applied to the respective actuator (11) from the voltage which is generated on the actuators (11).

17. Arrangement according to the preceding claim, wherein each of the piezoelectric actuators (11) can be read out and driven separately from the other piezoelectric actuators (11).

18. Arrangement according to either of Claims 16 and 17,
wherein the evaluation unit is designed to convert the pressure profiles into gestures of a gesture control operation.

19. Medical device having an arrangement according to one of the preceding claims.

20. Machine for industrial use having an arrangement according to one of Claims 1 to 18.

21. Kitchen appliance having an arrangement according to one of Claims 1 to 18.

22. Electronic vaporization device having an arrangement according to one of Claims 1 to 18.

23. Electronic device having an arrangement according to one of Claims 1 to 18.

24. Electronic device according to the preceding claim, wherein the electronic device is a mobile telephone, a tablet, a laptop, a smartwatch or a fitness, heart rate, sleep or health tracker.

25. Stylus having an arrangement according to one of Claims 1 to 18.

26. Stylus according to the preceding claim, wherein the component (1) for generating the haptic signal causes a sensing tip of the stylus to vibrate, or wherein the component (1) for generating the haptic signal causes a region of a housing of the stylus to vibrate.

**Revendications**

1. Agencement,

présentant un élément de commande (2) et un composant (1) destiné à générer un signal haptique, qui présente un actionneur piézoélectrique (11),
dans lequel le composant (1) est disposé sous l'élément de commande (2) et est conçu générer une vibration au niveau de l'élément de commande (2), l'élément de commande (2) étant une zone (4) d'une paroi de boîtier (3),
dans lequel la paroi de boîtier (3) présente une plus grande aptitude à la déformation mécanique dans la zone (4) servant d'élément de commande (2) que dans d'autres zones (5).

2. Agencement selon la revendication précédente, dans lequel l'élément de commande (2) et le composant (1) destiné à générer un signal haptique constituent un ensemble.

3. Agencement selon l'une quelconque des revendications précédentes, dans lequel l'actionneur piézoélectrique (11) est conçu pour être déformé suite à un actionnement de l'élément de commande (2) et pour détecter alors l'actionnement de l'élément de commande (2) .

4. Agencement selon l'une quelconque des revendications précédentes,

dans lequel la paroi de boîtier est plus fine dans la zone (4) servant d'élément de commande (2) que dans une autre zone,
et/ou
dans lequel la zone (4) de la paroi de boîtier servant d'élément de commande (2) est séparée des autres zones (5) de la paroi de boîtier par au moins une encoche.

5. Agencement selon l'une quelconque des revendications précédentes, dans lequel un symbole qui indique une fonction de commande est disposé sur la zone (4) de la paroi de boîtier (3) qui constitue l'élément de commande (2).

6. Agencement selon l'une quelconque des revendications précédentes, dans lequel le composant (1) destiné à générer un signal haptique est pris en sandwich entre l'élément de commande (2) et une paroi arrière (32).

7. Agencement selon la revendication précédente,

dans lequel une rigidité de la paroi arrière (32) est supérieure à une rigidité de l'actionneur piézoélectrique (11),
et/ou
dans lequel une rigidité de l'actionneur piézoélectrique (11) est supérieure à une rigidité de l'élément de commande (2).

8. Agencement selon l'une quelconque des revendications 6 ou 7, dans lequel l'élément de commande (1) et la paroi arrière (32) sont solidaires l'un de l'autre.

9. Agencement selon l'une quelconque des revendications 6 à 8, dans lequel le composant (1) destiné à générer un signal haptique est fixé à l'élément de commande (2) et/ou à la paroi arrière (32) .

10. Agencement selon l'une quelconque des revendications précédentes, dans lequel le composant (1) présente un élément de renforcement mécanique (13a, 13b) qui est fixé à l'actionneur piézoélectrique (11) de telle sorte qu'une variation de longueur de l'actionneur piézoélectrique (11) dans sa direction longitudinale déplace une zone (19a, 19b) de l'élément de renforcement mécanique dans une direction perpendiculaire à la direction longitudinale.

11. Agencement selon la revendication précédente, dans lequel l'élément de renforcement mécanique (13a, 13b) est une attache métallique.

12. Agencement selon l'une quelconque des revendications 10 ou 11,

dans lequel l'élément de renforcement mécanique (13a, 13b) est exempt d'entailles et présente une épaisseur de paroi constante,
ou
dans lequel l'élément de renforcement mécanique (13a, 13b) présente au moins une entaille qui réduit une résistance mécanique à une déformation de l'élément de renforcement mécanique.

13. Agencement selon l'une quelconque des revendications précédentes, présentant plusieurs composants (1) destinés à générer un signal haptique qui présentent respectivement un actionneur piézoélectrique (11) et qui sont disposés les uns à côté des autres sous forme de matrice.

14. Agencement selon la revendication précédente, dans lequel chacun des actionneurs piézoélectriques (11) peut être lu et piloté séparément des autres actionneurs piézoélectriques (11).

15. Agencement selon l'une quelconque des revendications 13 ou 14,

dans lequel la matrice de composants (1) est conçue pour identifier une commande gestuelle de l'élément de commande (2),
dans lequel l'appareil électronique présente en outre une unité d'évaluation qui est conçue pour lire la tension électrique générée au niveau de chacun des actionneurs piézoélectriques (11), pour conclure à partir de la tension générée au niveau des actionneurs (11) au profil de pression appliqué à l'actionneur (11) respectif, et pour convertir les profils de pression en gestes de la commande gestuelle.

16. Agencement, présentant

une paroi de boîtier (3) qui présente une zone (4) qui est conçue pour être utilisée comme élément de commande, et plusieurs composants (1) destinés à générer un signal haptique qui présentent respectivement un actionneur piézoélectrique (11), dans lequel les composants (1) sont disposés les uns à côté des autres sous forme de matrice, et dans lequel les composants (1) sont disposés sous la zone (4) de la paroi de boîtier (3), dans lequel la paroi de boîtier (3) présente une plus grande aptitude à la déformation mécanique dans la zone (4) servant d'élément de commande (2) que dans d'autres zones (5), et
une unité d'évaluation qui est conçue pour lire la tension électrique générée au niveau de chacun des actionneurs piézoélectriques (11), et pour conclure à partir de la tension générée au niveau des actionneurs (11) au profil de pression appliqué à l'actionneur (11) respectif.

17. Agencement selon la revendication précédente, dans lequel chacun des actionneurs piézoélectriques (11) peut être lu et piloté séparément des autres actionneurs piézoélectriques (11).

18. Agencement selon l'une quelconque des revendications 16 ou 17, dans lequel l'unité d'évaluation est conçue pour convertir les profils de pression en gestes d'une commande gestuelle.

19. Appareil médical présentant un agencement selon l'une quelconque des revendications précédentes.

20. Machine destinée à une utilisation industrielle, présentant un agencement selon l'une quelconque des revendications 1 à 18.

21. Appareil ménager présentant un agencement selon l'une quelconque des revendications 1 à 18.

22. Appareil de vaporisation électronique présentant un agencement selon l'une quelconque des revendications 1 à 18.

23. Appareil électronique présentant un agencement selon l'une quelconque des revendications 1 à 18.

24. Appareil électronique selon la revendication précédente, dans lequel l'appareil électronique est un téléphone mobile, une tablette, un ordinateur portable, une montre intelligente ou un tracker de condition physique, de rythme cardiaque, de sommeil ou de santé.

25. Stylet présentant un agencement selon l'une quelconque des revendications 1 à 18.

26. Stylet selon la revendication précédente, dans lequel le composant (1) destiné à générer le signal haptique fait vibrer une pointe de palpage du stylet, ou dans lequel le composant (1) destiné à générer le signal haptique fait vibrer une zone d'un boîtier du stylet.

Fig. 1

Fig. 2

Fig. 3

Fig. 4

Fig. 5

Fig. 6

Fig. 7

2, 3

13a
11
13b    1         1          1          1

Fig. 8

30

27

3

2,4

31

29

28

Fig. 9

30

27

3

2,4

1

29

28

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2889727 A1